Europäisches Patentamt

European Patent Office

Office européen des brevets

(19)

(11) **EP 0 763 899 A1**

(12) **DEMANDE DE BREVET EUROPEEN**

(43) Date de publication:
**19.03.1997 Bulletin 1997/12**

(51) Int Cl.$^6$: **H03M 1/20**, H04N 7/26, H04N 5/44

(21) Numéro de dépôt: **96401909.5**

(22) Date de dépôt: **06.09.1996**

(84) Etats contractants désignés:
**DE FR GB IT**

(30) Priorité: **15.09.1995 FR 9510840**

(71) Demandeur: **THOMSON multimedia**
**92050 Paris La Défense (FR)**

(72) Inventeur: **Boie, Werner**
**92050 Paris la Defense Cedex (FR)**

(74) Mandataire: **Ruellan-Lemonnier, Brigitte**
**THOMSON Multimedia,**
**9 Place des Vosges**
**La Défense 5**
**92050 Paris La Défense (FR)**

(54) **Procédé pour la numérisation de signaux à fréquence intermédiaire FI en particulier de signaux vidéo, et circuit pour la mise en oeuvre de ce procédé**

(57) Procédé pour numériser, avec une précision supérieure à N bits, des signaux à fréquence intermédiaire FI, en particulier des signaux vidéo, à l'aide d'un convertisseur A/D (3) donnant, sur sa sortie, des signaux numériques à seulement N bits, selon lequel:

- on effectue un échantillonnage des signaux dans un échantillonneur-bloqueur (4) à une fréquence $f_S$, avec une précision correspondant à Q bits, Q étant supérieur à N ;
- on ajoute aux signaux échantillonnés, un signal (6) en rampe d'une amplitude (h) correspondant sensiblement à celle d'un bit de moindre poids (LSB) du convertisseur A/D (3) ;
- on envoie sur l'entrée du convertisseur A/D (3) la somme de chaque signal échantillonné et du signal en rampe (6), et on fait travailler le convertisseur A/D (3) à une fréquence $nf_S$, multiple $f_S$, de sorte qu'à la sortie du convertisseur A/D (3) on obtient des signaux numériques à la fréquence $nf_S$,

- et on effectue la moyenne de p signaux numériques pour obtenir, à une fréquence inférieure, égale à $nf_S/p$, des signaux numérisés ayant un nombre de bits supérieur à N.

FIG. 1

## Description

L'invention est relative à un procédé pour la numérisation de signaux à fréquence intermédiaire FI avec une précision supérieure à N bits, à l'aide d'un convertisseur analogique/numérique donnant, sur sa sortie, des signaux numériques à seulement N bits.

Actuellement, il y a une tendance ininterrompue à numériser les signaux de toutes sortes dans les installations de télévision (installations TV). Les raisons en sont diverses mais on peut dire que les techniques de traitement des signaux numériques permettent, d'une manière générale, d'accomplir de façon plus souple et plus économique les fonctions de traitement, filtrage et démodulation des signaux, que ne le permettent les solutions analogiques.

La numérisation des signaux dans la partie du dispositif d'accord ou dans le circuit FI (circuit à fréquence intermédiaire) pose encore aujourd'hui de sérieux problèmes. Une difficulté majeure réside dans les performances insuffisantes des convertisseurs analogiques/numériques (ou convertisseurs A/D) disponibles à des prix acceptables sur le marché, notamment en ce qui concerne une résolution dynamique élevée pour permettre en particulier de supprimer les signaux des canaux adjacents.

En supposant que dix bits sont suffisants pour la numérisation du signal composite superposé par les signaux son modulés, les exigences pour la suppression des canaux adjacents demandent des bits supplémentaires. Il faut supposer, en principe, que le signal numérique FI après la démodulation vidéo offre au moins les mêmes performances que le traitement analogique. Ceci signifie qu'en conséquence les bits supplémentaires doivent permettre une suppression suffisante des canaux adjacents au moyen d'un traitement des signaux numériques après numérisation du signal FI. Dans la pratique, il peut arriver que les signaux des canaux adjacents aient des amplitudes très nettement supérieures, jusqu'à 50 dB, à l'amplitude du signal désiré ce qui nécessite, pratiquement, une résolution augmentée d'environ 8 bits. La résolution totale doit donc s'élever à environ 18 bits.

Il s'agit là d'une exigence considérable à laquelle ne peuvent satisfaire les convertisseurs A/D actuellement disponibles sur le marché à des prix acceptables.

L'invention a pour but, surtout, de fournir un procédé permettant de numériser des signaux à fréquence intermédiaire FI avec une précision supérieure au nombre de bits N fournis par le convertisseur analogique/numérique, sans entraîner pour autant une augmentation trop importante du coût du procédé.

Selon l'invention, un procédé pour la numérisation des signaux à fréquence intermédiaire FI, avec une précision supérieure à N bits, à l'aide d'un convertisseur A/D donnant, sur sa sortie, des signaux numériques à N bits, est caractérisé par le fait que :

- on effectue un échantillonnage des signaux analogiques avant leur numérisation, dans un échantillonneur-bloqueur à une fréquence $f_S$, et avec une précision correspondant à Q bits, Q étant supérieur à N ;
- on ajoute aux signaux échantillonnés, un signal en forme de rampe ayant une amplitude de pic à pic sensiblement égale à celle correspondant au bit de moindre poids du convertisseur A/D ;
- on envoie sur l'entrée du convertisseur A/D la somme des signaux échantillonnés et du signal en rampe, et on fait travailler le convertisseur A/D à une fréquence d'échantillonnage $nf_S$, multiple de $f_S$, de sorte qu'à la sortie du convertisseur A/D on obtient des signaux numériques à la fréquence $nf_S$,
- et on effectue la moyenne de p signaux numérisés pour obtenir des valeurs moyennes des signaux numérisés ayant un nombre de bits supérieur à N, à une fréquence inférieure à $nf_S$.

De préférence, on choisit p égal à n.

Généralement on choisit n égal à une puissance de 2, $n = 2^M$, de sorte que le niveau de précision de la moyenne de n signaux à N bits devient (N + M) bits. On choisit Q au moins égal à la somme N + M.

Dans un exemple de réalisation, N est égal à 10, tandis que M est égal à 8.

Généralement, la moyenne est effectuée sur des signaux numérisés successifs, notamment sur un lot de n signaux numérisés, provenant du convertisseur A/D, lorsque p est égal à n.

L'invention est également relative à un circuit pour une numérisation de signaux à fréquence intermédiaire FI, ce circuit comprenant un convertisseur A/D propre à donner, sur sa sortie, des signaux numériques à N bits, ce circuit étant caractérisé par le fait qu'il comporte un échantillonneur-bloqueur dont l'entrée reçoit les signaux analogiques à numériser, cet échantillonneur-bloqueur fonctionnant à une fréquence d'échantillonnage $f_S$ et étant propre à fournir des signaux échantillonnés correspondant à une précision de Q bits, Q étant supérieur à N ; un générateur de signal en rampe d'une amplitude pic à pic correspondant sensiblement à celle d'un bit de moindre poids du convertisseur A/D ; un circuit additionneur propre à ajouter aux signaux échantillonnés le signal en rampe et à envoyer, sur l'entrée du circuit A/D la somme ainsi obtenue ; des moyens de commande pour faire fonctionner le circuit A/D à une fréquence d'échantillonnage $nf_S$, multiple de $f_S$, de sorte qu'à la sortie du convertisseur A/D les signaux numériques à N bits sont fournis à une fréquence $nf_S$ ; et un circuit propre à effectuer une moyenne de p signaux numérisés pour obtenir des valeurs numériques moyennes ayant un nombre de bits supérieur à N, à une fréquence inférieure à $nf_S$.

De préférence, le circuit de calcul de moyenne effectue une moyenne sur n signaux numérisés successifs et donne des valeurs moyennes numériques à la fréquence $f_S$.

Le générateur de signal en rampe est avantageusement constitué par un synthétiseur direct numérique comprenant un générateur de signaux numériques en escalier, un convertisseur digital/analogique et un filtre dont la sortie est reliée à une entrée du circuit additionneur.

De préférence un filtre médian est disposé entre la sortie du convertisseur A/D et l'entrée du circuit propre à établir la moyenne de p signaux numérisés.

Le circuit pour calculer la moyenne peut comporter un circuit correcteur d'erreur d'intervalle de quantification du convertisseur A/D.

L'invention consiste, mises à part les dispositions exposées ci-dessus, en un certain nombre d'autres dispositions dont il sera plus explicitement question ci-après à propos d'un exemple de réalisation décrit avec référence aux dessins ci-annexés, mais qui n'est nullement limitatif.

La figure 1 de ces dessins est un schéma d'un circuit pour numériser des signaux à fréquence intermédiaire FI selon l'invention.

La figure 2 est un schéma d'une partie du circuit de la figure 1 complétée par une allure des signaux en différents points de cette partie du circuit.

La figure 3 est un diagramme illustrant l'échantillonnage dans le convertisseur analogique/numérique.

La figure 4, est un diagramme de conversion du convertisseur analogique/numérique.

La figure 5 est un schéma simplifié d'un circuit pour calculer une moyenne avec correction d'erreur.

La figure 6, enfin, est un diagramme semblable à celui de la figure 4, avec caractéristique corrigée.

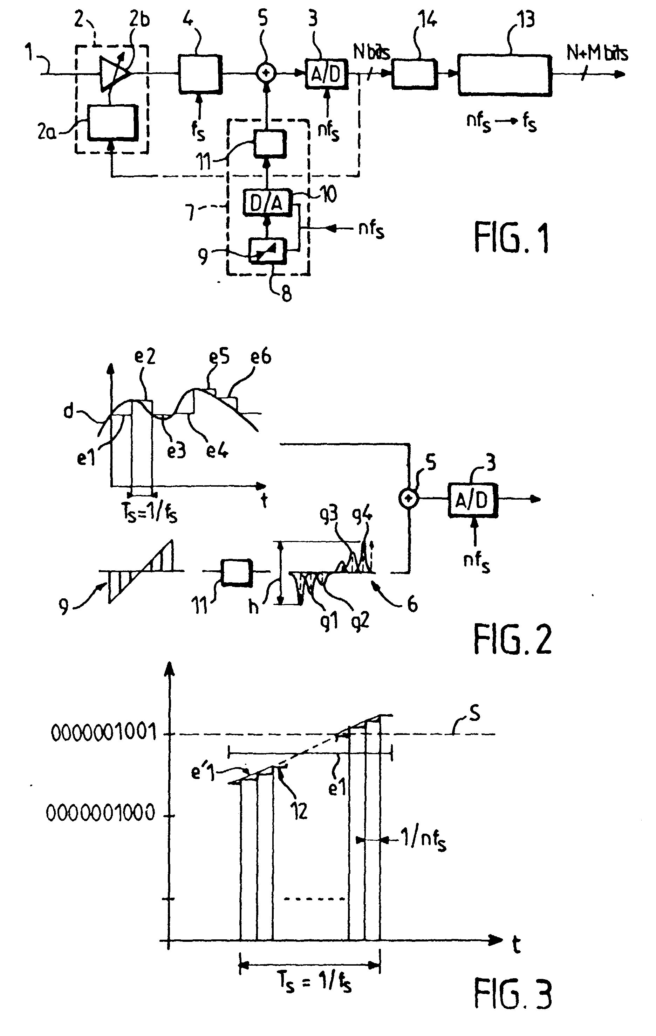

En se reportant à la figure 1, on peut voir un circuit pour numériser un signal de fréquence intermédiaire FI, en particulier un signal vidéo en télévision. Le signal FI à numériser délivré sur la ligne 1 provient d'un dispositif d'accord (ou "tuner") classique non représenté dont l'entrée est reliée à une antenne captant les signaux à traiter. Ce dispositif d'accord comporte un oscillateur local réglé sur une fréquence adaptée à celle des signaux captés par l'antenne pour créer un battement et fournir en sortie du dispositif d'accord un signal dont la fréquence correspond à la valeur normalisée de la fréquence intermédiaire FI dans le domaine considéré.

Le signal FI, arrivant par la ligne 1 sous forme analogique, est envoyé sur l'entrée d'un circuit 2 à commande automatique de gain (CAG) destiné à assurer que le signal qui sera fourni à l'entrée du convertisseur analogique/numérique (A/D) 3 sera bien adapté à la gamme d'amplitudes disponible de ce convertisseur. Un circuit de commande 2a, du circuit 2, réglant le gain d'un amplificateur 2b, peut être alimenté par le signal de sortie du convertisseur A/D comme représenté schématiquement par une ligne en tirets, ou peut être alimenté par un signal de sortie d'un bloc de traitement du signal numérique, non représenté sur la figure 1.

Le signal analogique FI amplifié correctement par le circuit 2 est délivré à l'entrée d'un échantillonneur-bloqueur 4 propre à assurer pour les signaux fournis sur sa sortie une précision élevée correspondant à Q bits. Dans l'exemple considéré Q est égal à 18 bits.

Cet échantillonneur-bloqueur 4 travaille à une fréquence d'échantillonnage $f_S$.

On se reporte maintenant à la partie supérieure gauche de la figure 2 qui est un diagramme (le temps est porté en abscisse, l'amplitude des signaux est portée en ordonnée) représentant par la courbe d le signal FI amplifié fourni à l'entrée de l'échantillonneur-bloqueur 4 et par des segments horizontaux e1, e2 ... e6, les signaux échantillonnés fournis en sortie par le circuit 4. L'ordonnée d'un segment tel que e1 correspond à celle du signal d au début de la période d'échantillonnage, et cette valeur est conservée pour le segment e1 pour la durée de la période d'échantillonnage $T_S$ qui est égale à $1/fS$. Ainsi, d'une manière classique, le signal analogique continu d est remplacé, en sortie du circuit 4, par une succession de segments e1, e2 ... horizontaux, permettant par la suite la numérisation, et représentant le signal analogique d'entrée.

La précision de l'ordonnée de chaque segment e1, e2 ... dépend de la précision de l'échantillonneur-bloqueur 4. Ce dernier est choisi de manière à fournir une précision de Q bits pour chaque segment e1 ... c'est-à-dire que si l'ordonnée de ce segment était exprimée en bits, l'échantillonneur-bloqueur 4 permettrait d'obtenir Q bits significatifs, Q étant égal à 18 pour l'exemple considéré.

L'échantillonneur-bloqueur 4 est choisi de manière à avoir un temps d'établissement et d'ouverture très faible. La largeur de bande de l'échantillonneur-bloqueur 4 est au moins égale à la fréquence FI maximale à numériser et est de préférence supérieure à cette fréquence pour éviter les effets supplémentaires de non-linéarité.

La fréquence d'échantillonnage $f_S$ peut être de l'ordre de 27 MHz alors que la fréquence intermédiaire FI peut être plus élevée, notamment de l'ordre de 40 MHz.

La sortie de l'échantillonneur-bloqueur 4 est reliée à l'entrée d'un circuit additionneur 5 dont une autre entrée reçoit un train d'impulsions 6 (voir figure 2) formant un signal échelonné ou rampe, provenant d'un synthétiseur direct numérique 7 (figure 1). L'amplitude h (figure 2) pic à pic du train d'impulsions 6 est sensiblement égale à celle correspondant au bit de moindre poids (LSB) du convertisseur A/D 3.

Comme visible sur la figure 1, le train d'impulsions 6 (appliqué sur l'autre entrée de l'additionneur 5) est obtenu à partir d'un générateur 8 fournissant un train de signaux numériques échelonnés 9 (figure 2) à une fréquence $nf_S$, multiple de la fréquence d'échantillonnage $f_S$ de l'échantillonneur-bloqueur 4. n est choisi égal à une puissance de 2, c'est-à-dire que $n = 2^M$. Dans l'exemple considéré, M est choisi égal à 8 de sorte que n est égal à 256.

Le train de signaux 9 numériques est fourni à un convertisseur numérique/analogique D/A 10, travaillant à la même fréquence $nf_S$ que le circuit 8. Le signal de sortie du convertisseur 10 traverse un filtre passe-bande 11 avant d'être envoyé, sous la forme du train d'impulsions 6, sur l'autre entrée de l'additionneur 5.

A la sortie de l'additionneur 5 le train d'impulsions est ajouté, c'est-à-dire superposé, au signal échantillonné en forme de segment horizontal arrivant sur l'autre entrée. La figure 3(temps en abscisse, amplitude en ordonnée) illustre schématiquement la transformation d'un segment échantillonné horizontal e1 par exemple en un signal e'1 en forme de rampe du fait de l'addition du train d'impulsions 6. La rampe e'1 croissante avec le temps coupe le segment e1 sensiblement au milieu.

Le convertisseur 3 travaille à une fréquence d'horloge (fréquence d'échantillonnage) égale à $nf_S$, c'est-à-dire multiple et n fois supérieure à la fréquence $f_S$ d'échantillonnage de l'échantillonneur-bloqueur 4.

Le convertisseur 3 effectue donc, en quelque sorte, un suréchantillonnage.

Comme déjà indiqué de préférence $n = 2^M$ avec, dans l'exemple considéré M = 8 et n = 256.

En se reportant à la figure 3, on voit que, dans ces conditions, la rampe e'1 qui a une durée égale à $T_S$ (soit $1/f_S$) sera échantillonnée n fois par le convertisseur 3 et donnera naissance à n valeurs échantillonnées, représentées par l'escalier 12 de la figure 3.

Le convertisseur A/D 3 a une résolution de N bits, N étant inférieur à Q. Dans l'exemple considéré N est égal à 10 bits. Sur la figure 3 on a représenté, en ordonnée, par des graduations les niveaux de quantification correspondant aux bits successifs, assurés par le convertisseur 3.

Il apparaît qu'un signal échantillonné tel que e1 dont l'amplitude est située entre deux niveaux de quantification serait converti, normalement, en une valeur numérique correspondant au niveau inférieur de quantification. La précision de conversion serait donc seulement égale à l'amplitude du bit de moindre poids correspondant à une graduation de l'échelle des ordonnées sur la figure 3.

L'invention permet d'améliorer considérablement cette précision. En effet, en ajoutant au segment e1 une rampe dont l'amplitude est sensiblement égale à celle du bit de moindre poids (LSB) du convertisseur 3, on est assuré que cette rampe franchira un seuil de quantification du convertisseur 3. Comme l'escalier 12 est formé de n segments horizontaux, ceux de ces segments inférieurs au seuil de quantification seront numérisés avec une valeur correspondant au niveau inférieur au seuil S, tandis que ceux de ces segments supérieurs au seuil de quantification S seront numérisés avec une valeur supérieure d'un bit, correspondant au seuil S.

Il devient alors possible, pour un segment e1 d'établir une moyenne pondérée des valeurs numériques des différents segments élémentaires de l'escalier 12 et d'obtenir ainsi une valeur numérique beaucoup plus précise pour le segment e1. La moyenne pondérée étant effectuée sur n segments élémentaires, avec $n = 2^M$, on peut obtenir, pour chaque segment tel que e1, une valeur moyenne avec un nombre de bits égal à N + M soit, dans l'exemple considéré 10 + 8 = 18 bits.

En outre, Q (précision de l'échantillonneur-bloqueur 4) est choisi au moins égal à N + M. Le calcul de la moyenne sur n valeurs numériques successives fournies par le convertisseur 3, à la fréquence $nf_S$, est effectué par un circuit 13 (figure 1) qui va donc donner sur sa sortie, à une fréquence $f_S$ des valeurs numériques avec N + M bits.

Un filtre médian 14 est avantageusement prévu entre la sortie du convertisseur 3 et l'entrée du circuit 13 pour éliminer les effets dus au bruit, lequel devient de plus en plus important lorsque le signal d'entrée du convertisseur 3 est proche du seuil de quantification. Ce filtre médian 14 présente l'avantage de ne pas dégrader les transitions à condition que la fenêtre du filtre ne soit pas trop large par rapport à la largeur de transition du signal à filtrer.

Enfin, le calcul de la moyenne, dans le circuit 13, est effectué de préférence avec une correction d'erreur dont il sera question plus loin, car on ne peut considérer que les seuils de quantification du convertisseur A/D sont tous régulièrement espacés.

Une caractéristique connue des convertisseurs A/D, du type convertisseur de flèche (flash converter) avantageusement utilisé dans le cas de l'invention, réside dans une perte de linéarité différentielle pour des taux de balayage d'entrée élevés. Ceci est principalement dû à des désadaptations de synchronisation, de sorte que les échantillons sont prélevés sur le signal d'entrée à des instants qui ne correspondent pas toujours à ceux souhaités, notamment en raison de l'instabilité de la base de temps qui détermine les périodes d'échantillonnage. L'erreur causée par l'instabilité de la base de temps augmente également pour des fréquences d'entrée élevées. Pour ces raisons, la fréquence d'entrée doit être conservée aussi faible que possible. C'est une raison pour laquelle le signal en forme de rampe, superposé dans l'additionneur 5 aux signaux échantillonnés, doit produire au maximum deux changements dans le code de sortie du convertisseur A/D 3 sur un intervalle d'échantillonnage du signal FI. En conséquence, le comportement transitoire du convertisseur A/D 3 a un très faible effet sur le résultat. En même temps, l'hystérésis sera évitée car le seuil de quantification sera traversé dans une seule direction. Ceci provoque plus ou moins une erreur fixe qui peut être corrigée ultérieurement.

La sensibilité à l'instabilité de la base de temps peut aussi être fortement réduite si le signal d'entrée du convertisseur A/D 3 est échantillonné aux valeurs maximales telles que g1, g2, g3, g4 (figure 2) du train d'impulsions superposés 6.

Le synthétiseur direct numérique 7 consiste comme déjà indiqué, en un générateur 8 de train d'impulsions numériques 9, un convertisseur numérique/analogique 10 à vitesse élevée et un filtre passe-bande 11. Les impulsions sont crées de telle sorte que l'amplitude maximale de chaque échantillon soit sensiblement indépendante de celle des autres. L'échantillonnage dans le convertisseur A/D 3 devrait se produire juste à l'instant où les impulsions atteignent leur maximum tel que g1, g2, g3, g4. Au voisinage de ce maximum, une instabilité de la base de temps a la plus faible influence sur le signal de sortie du convertisseur A/D 3.

La fenêtre d'échantillonnage résultante dépend, bien sûr, de la résolution désirée pour les impulsions. La largeur de fenêtre définit la plage de temps sur laquelle l'horloge du convertisseur A/D peut dériver. Une fenêtre large aura pour effet une sensibilité moindre à l'instabilité de la base de temps du convertisseur A/D.

En supposant qu'une impulsion au voisinage de son maximum est voisine d'une onde sinusoïdale, on peut calculer que la fenêtre de numérisation au sommet de l'impulsion est d'environ 2,8 % de la période d'échantillonnage du convertisseur A/D pour $n = 8$ bits. Cette exigence peut conduire à une fenêtre d'amplitude très réduite dans le temps pour des vitesses d'échantillonnage élevées. En raison de ces exigences importantes, il est préférable que le synthétiseur direct numérique 7 fournisse directement une fonction en échelons. Ceci est possible car les interférences entre symboles se produisant sont connues et ne sont pas si dommageables puisque le signal superposé varie seulement de $1/2^n$ pendant la période d'horloge d'échantillonnage. Il est également possible de modifier le signal afin de permettre une décharge contrôlée de la capacité dans le circuit échantillonneur-bloqueur 4, ce qui simplifierait sa réalisation d'un point de vue matériel.

Il est souvent indiqué que l'utilisation d'un signal de tremblement (ou dither) permettrait de linéariser un quantificateur (caractéristique d'un convertisseur A/D) de telle sorte que des variations d'entrée beaucoup plus petites que l'intervalle de quantification seraient répercutées dans le signal de sortie. Il en résulte qu'un signal de tremblement (dither) devrait être utilisé pour minimiser les distorsions dans les quantificateurs classiques. Si un signal de tremblement est utilisé correctement, il est légitime de parler du signal non souhaité comme d'un bruit et la puissance d'un bruit s'il s'agit d'un bruit blanc s'étend sur toute la bande de base jusqu'à la limite de Nyquist déterminée par la fréquence de suréchantillonnage. Si la largeur de la bande de base est réduite par le facteur de suréchantillonnage de n pour revenir à la largeur de bande du signal d'entrée analogique original, la largeur de bande du bruit sera également réduite d'un facteur n, et la puissance de bruit sera le énième de celle produite au niveau du quantificateur. Mais un tel calcul n'est valable que si le bruit résultant, ce qui signifie le signal de bruit ajouté et le bruit de quantification provoqué du convertisseur A/D, représente un bruit blanc. Il est peu vraisemblable que ceci se produise. En outre un signal de bruit ajouté au signal d'entrée va causer des changements d'amplitude plus forts dans les comparateurs du convertisseur A/D de sorte que le comportement (transitoire) à fréquence élevée du convertisseur A/D comme mentionné précédemment devient plus important. En plus de cela, les exigences relatives à l'instabilité de la base de temps seraient plus fortes. Par ailleurs, la résolution ne peut être augmentée dans le convertisseur A/D sauf si un signal est ajouté au signal d'entrée analogique mais ce signal ajouté devrait rendre le signal résultant tel qu'il approche ou qu'il excède "tendrement" les seuils de quantification.

La caractéristique de quantification des convertisseurs A/D, et en particulier du convertisseur 3, présente certaines erreurs qui doivent être corrigées afin d'obtenir à la sortie du circuit un signal numérique FI ayant une résolution dynamique augmentée. Deux de ces erreurs sont très importantes, et il s'agit de la non-linéarité intégrale et différentielle. La première est responsable de l'apparition de résultats non linéaires à la sortie du convertisseur A/D tandis que la seconde a une influence significative sur le comportement de bruit.

Dans ce sens, ces erreurs ont la même signification que linéarité et bruit dans les circuits analogiques.

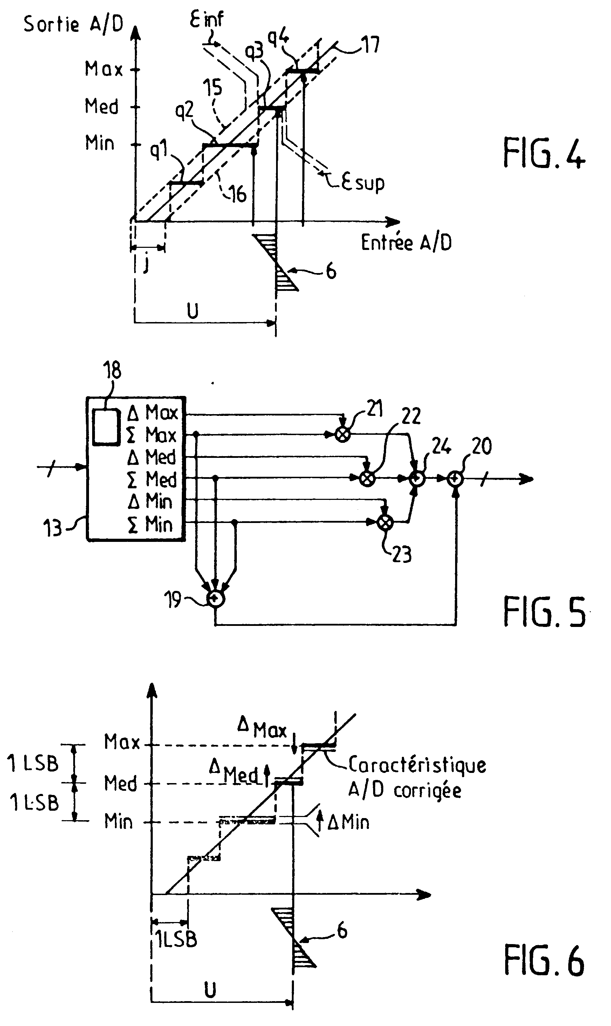

La figure 4 illustre la non-linéarité différentielle qui correspond à la quantité dont diffèrent en taille les intervalles de quantification adjacents. En ignorant le décalage de la ligne droite, les déviations des seuils de quantification à partir de la "meilleure ligne droite" provoquent un bruit de quantification supplémentaire à l'entrée. Pour des applications normales du convertisseur A/D, ces déviations atteignent environ un demi bit de moindre poids (LSB) de la plage du convertisseur A/D. Mais pour l'application ici présumée, ce niveau d'erreur n'est pas acceptable car il ne peut être corrigé ultérieurement. Ceci signifie que, bien que le convertisseur A/D ait un pouvoir de résolution de 10 bits, la précision des seuils de quantification devrait être de l'ordre de 14 bits pour rendre possible une correction sensible.

La figure 4 est un diagramme illustrant les variations des intervalles de quantification adjacents q1, q2, q3 ... L'amplitude du signal d'entrée sur le convertisseur A/D 3 est portée en abscisse, tandis que le signal de sortie est porté en ordonnée. L'amplitude théorique correspondant au bit de moindre poids (1 LSB) correspond au segment j. A partir de chaque extrémité du segment j on a tracé des lignes 15, 16 inclinées à 45° et, à partir du centre, une ligne 17 en trait plein également inclinée à 45°. Dans un convertisseur théorique parfait, tous les intervalles de quantification seraient égaux et formeraient un escalier à marches régulières entre les limites 15 et 16. En réalité, comme visible sur la figure 3, certains intervalles tels que q2 ont une longueur plus importante tandis que d'autres intervalles tels que q3 ont une longueur plus réduite. Par exemple pour l'intervalle q3, son extrémité gauche, au lieu de se trouver sur la ligne 15, se trouve écartée de celle-ci vers la droite d'une valeur correspondant à une erreur ε inf., tandis que l'extrémité droite du seuil q3 est située au-delà de la ligne 16 d'une distance correspondant à une erreur ε sup.. L'intervalle de quantification q3 correspond au signal U provenant de l'échantillonneur-bloqueur 4, signal sur lequel est superposée la rampe 6.

Ces erreurs conduisent au fait que la moyenne de tous les échantillons sur un intervalle Ts ne constitue pas une très bonne valeur approximative du signal d'entrée U.

Le signal en forme de rampe 6, sur la figure 4 présente, comme déjà indiqué, une amplitude pic à pic d'environ 1 bit de moindre poids (1LSB), c'est-à-dire environ égale à j selon la figure 4. Ce signal peut produire pendant l'intervalle de temps $T_S$ correspondant à une période, deux ou au maximum trois niveaux de signaux de sortie différents, pour une certaine valeur de U. Ces niveaux de signaux de sortie sont désignés par Min, Med et Max.

Pour permettre d'effectuer de manière simple la moyenne, les valeurs représentatives "correctes" correspondant aux seuils de quantification erronés de tous les intervalles de quantification doivent être mesurées et stockées dans une table d'exploration 18 (figure 5) prévue dans le circuit 13 pour effectuer la moyenne avec une correction d'erreur. Les erreurs mesurées DMin, DMed, et DMax sont stockées dans la table 18. Les sommes des valeurs Max, des valeurs Med et des valeurs Min non corrigées sont effectuées et sont additionnées dans un circuit additionneur 19 pour fournir en sortie une moyenne non corrigée envoyée sur un additionneur 20.

En outre, la valeur d'erreur DMax est envoyée sur l'entrée d'un multiplieur 21 dont l'autre entrée reçoit la valeur de la somme SMax.

Il en est de même pour les valeurs SMed et DMed au niveau du multiplieur 22 et pour les valeurs SMin et DMin au niveau du multiplieur 23. Les sorties des multiplieurs 21, 22, 23 sont envoyées sur trois entrées respectives d'un circuit additionneur 24 qui fournit en sortie un signal de correction envoyé sur une autre entrée du circuit additionneur 20, lequel fournit en sortie la moyenne corrigée de valeur C correspondant à l'algorithme suivant :

$$C = (SMax_{cor} + SMed_{cor} + SMin_{cor})/n$$

$$C = ([SMax + SMed + SMin] +$$
$$[D_{Max}SMax + D_{Med}SMed + D_{Min}SMin])/n$$

Il est à noter que cet algorithme permet un certain degré de correction des valeurs de sortie, mais qu'il est important que les seuils de quantification restent constants dans le temps, en particulier malgré les variations de température possibles. Sinon, les valeurs de correction doivent être adaptées en conséquence.

La figure 6 est un diagramme illustrant la caractéristique du convertisseur A/D corrigée en fonction des valeurs DMax, DMed et DMin.

Le suréchantillonnage du signal FI vidéo selon l'invention, permet de réaliser une conversion A/D multistandard avec une résolution dynamique suffisante, de l'ordre de 18 bits, alors que le convertisseur A/D utilisé ne fournit que 10 bits en sortie.

## Revendications

1. Procédé pour numériser, avec une précision supérieure à N bits, des signaux à fréquence intermédiaire FI, en particulier des signaux vidéo, à l'aide d'un convertisseur A/D donnant, sur sa sortie, des signaux numériques à seulement N bits, caractérisé par le fait que :

   - on effectue un échantillonnage des signaux dans un échantillonneur-bloqueur (4) à une fréquence $f_S$, avec une précision correspondant à Q bits, Q étant supérieur à N ;
   - on ajoute aux signaux échantillonnés, un signal (6) en rampe d'une amplitude (h) correspondant sensiblement à celle d'un bit de moindre poids (LSB) du convertisseur A/D (3) ;
   - on envoie sur l'entrée du convertisseur A/D (3) la somme de chaque signal échantillonné et du signal en rampe (6), et on fait travailler le convertisseur A/D (3) à une fréquence $nf_S$, multiple $f_S$, de sorte qu'à la sortie du convertisseur A/D (3) on obtient des signaux numériques à la fréquence $nf_S$,
   - et on effectue la moyenne de p signaux numériques pour obtenir, à une fréquence inférieure, égale à $nf_S/p$, des signaux numérisés ayant un nombre de bits supérieur à N.

2. Procédé selon la revendication 1, caractérisé par le fait que p est égal à n.

3. Procédé selon la revendication 1 ou 2, caractérisé par le fait que n est égal à une puissance de 2, (n = $2^M$), de sorte que le niveau de précision de la moyenne de n signaux numérisés est de N + M bits, Q étant au moins égal à N + M.

4. Procédé selon la revendication 3, caractérisé par le fait que M est égal à 8, n est égal à 10, et Q est au moins égal à 18.

5. Circuit pour la numérisation de signaux à fréquence intermédiaire FI, en particulier de signaux vidéo, avec une précision supérieure à N bits, à l'aide d'un convertisseur A/D (3) donnant sur sa sortie des signaux numériques à seulement N bits, caractérisé par le fait qu'il comprend :

   - un échantillonneur-bloqueur (4) recevant sur son entrée les signaux analogiques à convertir en numériques, cet échantillonneur-bloqueur travaillant à une fréquence $f_S$ et assurant une précision des signaux échantillonnés correspondant à Q bits, Q étant supérieur à N ;

- un générateur de signal en rampe (6) ayant une amplitude pic à pic sensiblement égale à celle correspondant à un bit de moindre poids du convertisseur A/D (3) ;

- un circuit additionneur (5) propre à ajouter, aux signaux échantillonnés, le signal échelonné et à envoyer la somme obtenue sur le convertisseur A/D (3) ;

- le convertisseur A/D (3) étant propre à fonctionner à une fréquence d'échantillonnage $nf_S$ multiple de celle de l'échantillonneur-bloqueur (4) et à fournir en sortie des signaux numériques à N bits, à la fréquence multiple $nf_S$;

- et un circuit (13) propre à effectuer la moyenne de p signaux numérisés, p étant inférieur ou égal à n, pour obtenir, en sortie, à une fréquence $nf_S/p$, des signaux numérisés ayant un nombre de bits supérieurs à N.

6. Circuit selon la revendication 5, caractérisé par le fait que le circuit (13) propre à établir une moyenne effectue la moyenne de n signaux numérisés (p = n).

7. Circuit selon la revendication 5 ou 6, caractérisé par le fait que l'échantillonneur-bloqueur (4) assure une précision correspondant à Q = 18 bits, que le convertisseur A/D (3) donne en sortie des signaux numériques à N = 10 bits, et que n = 8, de sorte que les signaux numériques obtenus à la sortie du circuit établissant la moyenne (13) sont des signaux à 18 bits.

8. Circuit selon l'une des revendications 5 à 7, caractérisé par le fait que le générateur (7) de signal échelonné est constitué par un synthétiseur direct numérique comprenant un générateur (8) de signal numérique en échelons, un convertisseur numérique/analogique (10), ce générateur (8) et ce convertisseur (10) fonctionnant à la fréquence $nf_S$.

9. Circuit selon l'une des revendications 5 à 8, caractérisé par le fait qu'il comprend un filtre médian (14) disposé entre la sortie du convertisseur A/D (3) et l'entrée du circuit (13) propre à établir la moyenne.

10. Circuit selon l'une revendications 5 à 9, caractérisé par le fait que le circuit (13) pour établir la moyenne est agencé pour effectuer une correction d'erreur d'intervalle de quantification du convertisseur A/D (3).

FIG. 1

FIG. 2

FIG. 3

EP 0 763 899 A1

FIG.4

FIG.5

FIG.6

9

Office européen
des brevets

**RAPPORT DE RECHERCHE EUROPEENNE**

Numero de la demande

EP 96 40 1909

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (Int.Cl.6) |
| X | GB-A-2 144 285 (BELCHER RAYMOND ALLAN) 27 Février 1985<br>* page 2, ligne 91 - page 3, ligne 15 *<br>* page 3, ligne 45-56; figures 1-3 *<br>--- | 1-8 | H03M1/20<br>H04N7/26<br>H04N5/44 |
| X | EP-A-0 520 662 (TDK CORP) 30 Décembre 1992<br><br>* colonne 2, ligne 28 - colonne 3, ligne 44; figure 1 *<br>--- | 1-3,5,6,8 | |
| A | EP-A-0 543 220 (THOMSON CONSUMER ELECTRONICS) 26 Mai 1993<br>* colonne 3, ligne 36 - colonne 4, ligne 17; figures 2-4 *<br>----- | 1,5 | |
| | | | DOMAINES TECHNIQUES RECHERCHES (Int.Cl.6)<br><br>H03M<br>H04N |

Le présent rapport a été établi pour toutes les revendications

| Lieu de la recherche | Date d'achèvement de la recherche | Examinateur |
|---|---|---|
| LA HAYE | 12 Décembre 1996 | Beindorff, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)